Europäisches Patentamt

European Patent Office

Office européen des brevets

(19)

(11) Veröffentlichungsnummer: **0 268 016 B1**

(12) **EUROPÄISCHE PATENTSCHRIFT**

(45) Veröffentlichungstag der Patentschrift: **02.05.91**

(21) Anmeldenummer: **87110091.3**

(22) Anmeldetag: **08.05.85**

(51) Int. Cl.⁵: **H05K 3/34**, H05K 3/30, H05K 7/12

(60) Veröffentlichungsnummer der früheren Anmeldung nach Art. 76 EPÜ: **0 165 434**

(54) **Verfahren zum Verbinden von in einem Halter gehaltenen Lumineszenzdioden mit einer Leiterplatte.**

(30) Priorität: **21.05.84 DE 3418844**

(43) Veröffentlichungstag der Anmeldung:
**25.05.88 Patentblatt 88/21**

(45) Bekanntmachung des Hinweises auf die Patenterteilung:
**02.05.91 Patentblatt 91/18**

(84) Benannte Vertragsstaaten:
**AT BE CH DE FR GB IT LI SE**

(56) Entgegenhaltungen:
**EP-A- 0 133 396**
**DE-A- 2 714 168**

(73) Patentinhaber: **Siemens Aktiengesellschaft**
**Wittelsbacherplatz 2**
**W-8000 München 2(DE)**

(72) Erfinder: **Meusel, Otto**
**Aufsessstrasse 18**
**W-8520 Erlangen(DE)**

## Beschreibung

Die Erfindung bezieht sich auf ein Verfahren zum Verbinden von in einem Halter mit Anschlußleitungen in Nuten gehaltenen Lumineszenzdioden mit Verbindungsöffnungen zur electrischen Verbindung an den Leiterbahnen einer Leiterplatte durch Einschieben der Anschlüsse in die Verbindungsöffnungen zur electrischen Verbindung anschließendem Verlöten in einem Bad.

Bei bekannten Verfahren der obengenannten Art (DE-27 18 442, A1, DE-GM 76 22 134) werden die Lumineszenzdioden mit abgewinkelten Anschlüssen in dem Halter befestigt und danach wird der Halter mit der Leiterplatte in Verbindung gebracht, wobei gleichzeitig die Anschlüsse der Lumineszenzdioden in Verbindungsöffnungen an den Leiterbahnen der Leiterplatte eingeschoben werden. Die Verlötung geschieht anschließend. Die Lumineszenzdioden sind hier auf der Seite der übrigen Bauelemente angeordnet, so daß gegebenenfalls hier auch eine Verlötung in einem Bad vorgenommen werden kann.

Aus DE-A- 2 741 168 ist außerdem ein Verfahren zum Verbinden einer lumineszenzdiode mit einer Leiterplatte bekannt, bei dem ein Halter für die lumineszenzdiode vorgesehen ist, der Haltezapfen aufweist, die zur mechanischen Verbindung in eine Öffnung der Leiterplatte eingesetzt werden und wobei ein Rasthaken aus Halter vorgesehen ist, der mit der Stirnseite der Leiterplatte verrastet wird.

Durch die Erfindung soll ein Verfahren geschaffen werden, mit dem es möglich ist, Lumineszenzdioden auf der den Bauelementen abgewandten Seite der Leiterplatte anzuordnen, wobei die Anschlüsse der Lumineszenzdioden in einem Arbeitsgang mit den Anschlüssen der übrigen Bauelemente in einem Bad verlötet werden sollen.

Diese Aufgabe wird durch das im Patentanspruch 1 definierte Verfahren gelöst.

Dies wird auf einfache Weise dadurch erreicht, daß der Halter gleichzeitig mit dem Einführen der Anschlußleitungen in die elektrischen Verbindungsöffnungen mit Haltezapfen in angepaßte mechanische Verbindungsöffnungen in der Leiterplatte eingeführt werden, und daß nach dem Verlöten der Halter um 90° verschwenkt wird, wobei die Haltezapfen abbrechen und der Halter mittels Rasthaken mit der Stirnseite der Leiterplatte verrastet wird.

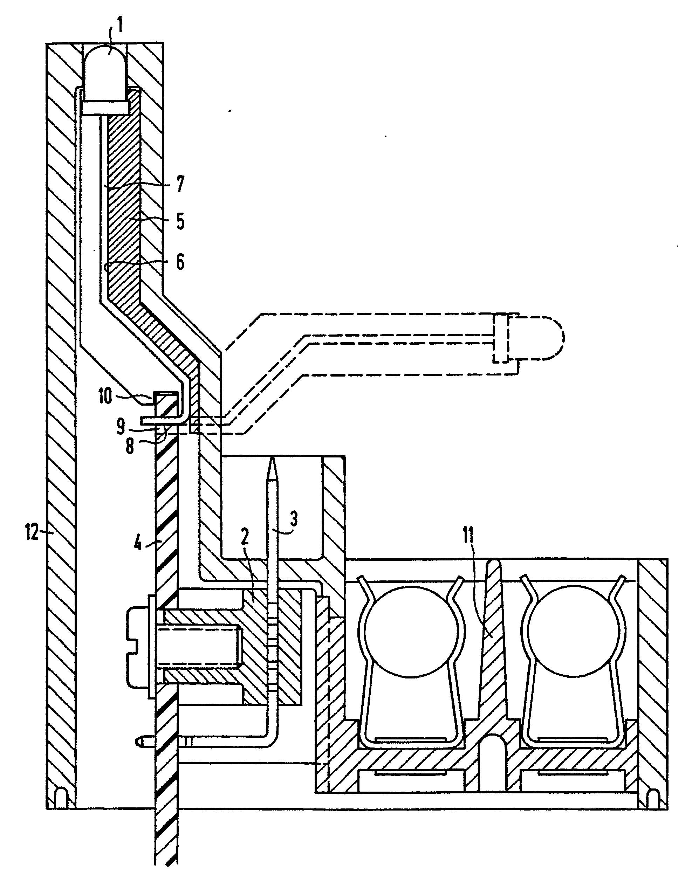

Anhand der Zeichnung wird durch ein Ausführungsbeispiel das Verfahren näher erläutert.

Wie die Zeichnung zeigt, sind die Lumineszenzdioden 1, um Platz für die Steckverbindungen zwischen einer Steckerleiste 2 mit den Steckanschlüssen 3 zu gewinnen, in bezug auf die Leiterplattenebene der Leiterplatte 4 derart angeordnet, daß sie beim Löten der Leiterplatte 4 in einem Tauchbad in das Tauchbad eintauchen würden. Um hier eine einfache Befestigungsmöglichkeit elektrischer und mechanischer Art zu schaffen, sind die Lumineszenzdioden in einem Halter 5 untergebracht, der mit Nuten 6 zum Einlegen der Anschlußleitungen 7 für die Lumineszenzdioden 1 versehen ist. Die Enden der Anschlußleitungen 7 werden in entsprechende Verbindungsöffnungen 8 der Leiterplatte 4 eingeschoben. Der Halter besitzt abbrechbare Haltezapfen 9, die in entsprechende Ausnehmungen der Leiterplatte 4 eingeschoben werden, ohne hierbei eine elektrische Verbindung herzustellen. Die Lage des Halters 5 ist gestrichelt angedeutet. Da die Lumineszenzdioden nunmehr auf der anderen Seite der Leiterplatte 4 liegen, kann die Leiterplatte ohne Schwierigkeiten verzinnt werden und hiermit die Anschlüsse für die Anschlußleitungen 7 hergestellt werden. Hernach brechen die Haltezapfen 9 beim Umklappen der Lumineszenzdiodenhalter 5 in die Betriebslage selbsstätig ab; die Anschlußleitungen 7 können durch entsprechende Schlitze im Halter 5 durchrutschen, und der Halter 5 kann sich mit den Rasthaken 10 um die Leiterplatte 4 herum verrasten und die aus der Zeichnung (voll ausgezogen) ersichtliche Lage annehmen. Die messerförmigen Steckanschlüsse 3, die Module 11, sowie der Halter 5 und damit die Lumineszenzdioden 1 selbst und auch die Leiterplatten 4 im oberen Bereich werden durch eine Kappe 12 abgedeckt, die Platz für eine nicht näher dargestellte Steckeinheit übrigläßt.

## Ansprüche

1. Verfahren zum Verbinden von in einem Halter (5) mit ihren Anschlußleitungen (7) in Nuten (6) gehaltenen Lumineszenzdioden (1) mit Verbindungsöffnungen zur elektrischen Verbindung (8) an den Leiterbahnen einer Leiterplatte durch Einschieben der Anschlüsse in die Verbindungsöffnungen zur elektrischen Verbindung (8) und anschliessendem Verlöten in einem Bad, wobei der Halter (5) gleichzeitig mit dem Einführen der Anschlußleitungen (7) in die Verbindungsöffnungen zur elektrischen Verbindung (8) mit Haltezapfen (9) in angepaßte Verbindungsöffnungen zur mechanischen Verbindung in der Leiterplatte (4) eingeführt werden, und wobei nach dem Verlöten der Halter (5) um 90° verschwenkt wird, so daß die Haltezapfen (9) abbrechen und der Halter (5) mittels Rasthaken (10) mit der Stirnseite der Leiterplatte (4) verrastet wird.

## Claims

1. Method for connecting luminescent diodes (1), held in a holder (5) with their connecting leads (7) in grooves (6), with connection apertures (8) for electrical connection, to the strip conductors of a printed board, by pushing the connections into the connection apertures (8) for electrical connection and by subsequent soldering in a bath, the holder (5) being introduced, at the same time as the introduction of the connecting leads (7) into the connection apertures (8) for electrical connection, with holding pegs (9) into matched connection apertures for mechanical connection in the printed board (4), and the holder (5) being swivelled by 90° after soldering, so that the holding pegs (9) break away and the holder (5) is latched by means of locking hooks (10) on to the front of the printed board (4).

**Revendications**

1. Procédé pour raccorder des diodes à luminescence (1) maintenues par leurs conducteurs de raccordement (7) dans des encoches (6) dans un support (5) et comportant des ouvertures de raccordement (8) servant à établir la liaison électrique avec les voies conductrices d'une plaquette à circuits imprimés moyennant l'insertion des bornes dans les ouvertures de raccordement (8) servant à établir la liaison électrique et le soudage ultérieur dans un bain, et selon lequel lors de l'introduction des conducteurs de raccordement (7) dans les ouvertures de raccordement (8) servant à établir la liaison électrique, on introduit simultanément le support (5) par des tétons de retenue (9) dans des ouvertures de raccordement adaptées qui serve à établir la liaison mécanique et qui sont ménagées dans la plaquette à circuits imprimés (4), et on fait pivoter le support (5) de 90° après le soudage de manière que les tétons de retenue (9) se rompent et que le support (5) s'encliquette au moyen de crochets d'encliquetage (10) sur la face frontale de plaquette à circuits imprimés (4).